# EUROPEAN PATENT APPLICATION

(11) **EP 4 694 634 A1**
(43) Date of publication of application: **11.02.2026**
(21) Application number: 23936302.1
(22) Date of filing: 07.08.2023
(51) Int. Cl.: H10K 39/10, H10K 30/40

(54) **LAMINATED SOLAR CELL AND PREPARATION METHOD THEREFOR, AND ELECTRICAL DEVICE**

(30) Priority: 06.05.2023 CN 202310499958
(71) Applicant: Contemporary Amperex Technology Co., Limited, Ningde, Fujian 352100 (CN)
(72) Inventor: TU, Bao, Ningde, Fujian 352100 (CN); CHEN, Changsong, Ningde, Fujian 352100 (CN); MA, Junfu, Ningde, Fujian 352100 (CN); ZHOU, Hongmei, Ningde, Fujian 352100 (CN); CHEN, Guodong, Ningde, Fujian 352100 (CN); LI, Yuelong, Ningde, Fujian 352100 (CN); GUO, Yongsheng, Ningde, Fujian 352100 (CN)
(74) Representative: Lorenz Seidler Gossel Part. mbB
(86) International application number: PCT/CN2023/111549
(87) International publication number: WO 2024/229995

(57) **Abstract**

Disclosed are a laminated solar cell and a preparation method therefor, and an electrical apparatus, which belong to the technical field of solar cells. The laminated solar cell includes: a first sub-cell, a tunneling structure and a second sub-cell which are sequentially arranged in a first direction, wherein the first direction is an incident direction of sunlight; the first sub-cell includes a first carrier transport layer, a first light absorption layer and a second carrier transport layer which are sequentially arranged in the first direction; the second sub-cell includes a third carrier transport layer, a second light absorption layer and a fourth carrier transport layer which are sequentially arranged in the first direction; and the tunneling structure includes a main body material layer and an auxiliary material layer, the main body material layer includes a metal-doped metallic oxide, the auxiliary material layer includes an N-type semiconductor material or a P-type semiconductor material, the auxiliary material layer is located between the main body material layer and the third carrier transport layer, and the main body material layer is located between the second carrier transport layer and the auxiliary material layer, thereby being beneficial to improving the efficiency and stability of the laminated solar cell.

## Description

### CROSS-REFERENCE TO RELATED APPLICATIONS

The present application claims priority to a patent application 2023104999589 filed on May 6, 2023 and entitled "LAMINATED SOLAR CELL AND PREPARATION METHOD THEREFOR, AND ELECTRICAL APPARATUS", which is incorporated herein by reference in its entirety.

### TECHNICAL FIELD

The present application relates to the technical field of solar cells, in particular to a laminated solar cell and a preparation method therefor, and an electrical apparatus.

### BACKGROUND

In recent years, the problems of global energy shortage and environmental pollution have become increasingly prominent, and a solar cell has attracted more and more attentions as an ideal renewable energy source. The solar cell, also known as a photovoltaic cell, is a device that directly converts light energy into electrical energy through a photoelectric effect or a photochemical effect. As a type of solar cell, a laminated solar cell has a good application prospect due to its high photoelectric conversion efficiency.

The provision of various film layers of the laminated solar cell is crucial to its stability, efficiency and other performance. Therefore, how to improve the efficiency of the laminated solar cell is an urgent technical problem to be solved.

### SUMMARY

The present application is conducted in view of the above problems, and its purpose is to provide a laminated solar cell and a preparation method therefor, and an electrical apparatus to improve the performance of the laminated solar cell.

In a first aspect, a laminated solar cell is provided, including: a first sub-cell, a tunneling structure and a second sub-cell which are sequentially arranged in a first direction. The first direction is an incident direction of sunlight. The first sub-cell includes a first carrier transport layer, a first light absorption layer, and a second carrier transport layer which are sequentially arranged in the first direction. The second sub-cell includes a third carrier transport layer, a second light absorption layer, and a fourth carrier transport layer which are sequentially arranged in the first direction. The tunneling structure includes a main body material layer and an auxiliary material layer. The main body material layer includes a metal-doped metallic oxide. The auxiliary material layer includes an N-type semiconductor material or a P-type semiconductor material. The auxiliary material layer is located between the main body material layer and the third carrier transport layer. The main body material layer is located between the second carrier transport layer and the auxiliary material layer.

An example of the present application provides the laminated solar cell, including the first sub-cell, the tunneling structure, and the second sub-cell which are sequentially arranged in the first direction. The tunneling structure is located between the first sub-cell and the second sub-cell, and can electrically connect the first sub-cell and the second sub-cell to form the laminated cell. The first sub-cell includes the first carrier transport layer, the first light absorption layer, and the second carrier transport layer which are sequentially arranged in the first direction. The second sub-cell includes the third carrier transport layer, the second light absorption layer, and the fourth carrier transport layer which are sequentially arranged in the first direction. The first light absorption layer and the second light absorption layer can generate an electron-hole pair under the irradiation of sunlight, and the first carrier transport layer, the second carrier transport layer, the third carrier transport layer, and the fourth carrier transport layer can transport electrons or holes. The tunneling structure includes the main body material layer and the auxiliary material layer. The main body material layer includes the metal-doped metallic oxide. The auxiliary material layer includes the N-type semiconductor material or the P-type semiconductor material. By providing the main body material layer, the resistance between the tunneling structure and the first sub-cell or the second sub-cell can be reduced, which is beneficial to improving a fill factor of the laminated solar cell. By providing the auxiliary material layer, it is beneficial to reducing the recombination of carriers between the tunneling structure and the first sub-cell or the second sub-cell. The auxiliary material layer is located between the main body material layer and the third carrier transport layer, which is beneficial to reducing the carrier loss between the second carrier transport layer and the third carrier transport layer. The main body material layer is located between the second carrier transport layer and the auxiliary material layer, which is beneficial to reducing the resistance between the second carrier transport layer and the third carrier transport layer, and is beneficial to improving the fill factor of the laminated solar cell. Therefore, the technical solution of the example of the present application is beneficial to improving the efficiency of the laminated solar cell.

In a possible implementation, the first carrier transport layer is a hole transport layer, the second carrier transport layer is an electron transport layer, the third carrier transport layer is a hole transport layer, the fourth carrier transport layer is an electron transport layer, and the auxiliary material layer includes the P-type semiconductor material.

In the above technical solution, a material of the auxiliary material layer is the P-type semiconductor material, and the third carrier transport layer is the hole transport layer. This is beneficial to reducing the carrier loss between the second carrier transport layer and the third carrier transport layer, and is beneficial to improving the efficiency of the laminated solar cell.

In a possible implementation, the P-type semiconductor material includes at least one of a compound (I) and a compound (II): 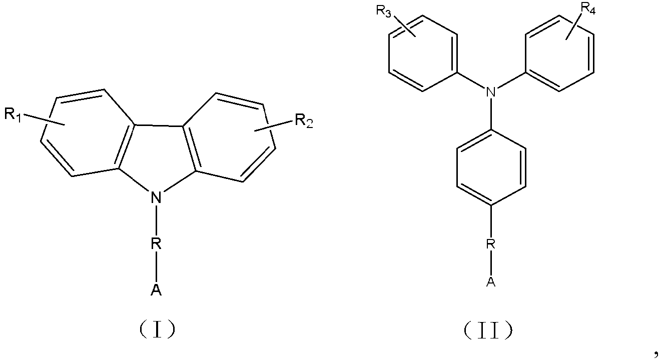
wherein A includes at least one of 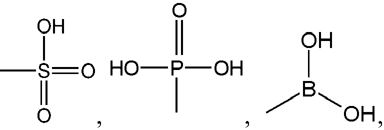 and -COOH;
R includes -(CH₂)ₙ-, where n is a natural number of 1 to 6; and
R₁, R₂, R₃, and R₄ each independently include at least one of -H, -CH₃, -C₂H₅, -OCH₃, - OC₂H₅, -X, -NH₂, and A, and X includes a halogen element. By selecting the above materials, the laminated solar cell has higher efficiency.

In a possible implementation, the P-type semiconductor material includes at least one of: [4-(3,6-dimethyl-9H-carbazol-9-yl)butyl]phosphoric acid, 2-(4-(diphenylamino)phenyl)acetic acid, and [4-(3,6-dimethoxy-9H-carbazol-9-yl)butyl]phosphonic acid. By selecting the above materials, the laminated solar cell has higher efficiency.

In a possible implementation, the first carrier transport layer is an electron transport layer, the second carrier transport layer is a hole transport layer, the third carrier transport layer is an electron transport layer, the fourth carrier transport layer is a hole transport layer, and the auxiliary material layer includes the N-type semiconductor material.

In the above technical solution, the material of the auxiliary material layer is the N-type semiconductor material, and the third carrier transport layer is the electron transport layer. This is beneficial to reducing the carrier loss between the second carrier transport layer and the third carrier transport layer, and is beneficial to improving the efficiency of the laminated solar cell.

In a possible implementation, the N-type semiconductor material includes tin dioxide. By selecting the tin dioxide as the material of the auxiliary material layer, the laminated solar cell has higher efficiency.

In a possible implementation, a thickness of the main body material layer is 0.5 nm-2 nm.

In the above technical solution, in a case where the thickness of the main body material layer is not less than 0.5 nm, it is helpful to reduce the difficulty of preparing the main body material layer and facilitate the preparation of the main body material layer. In a case where the thickness of the main body material layer does not exceed 2 nm, it is helpful to reduce the loss of carriers and facilitate the transport of carriers, thereby helping to improve the efficiency of the laminated solar cell.

In a possible implementation, the thickness of the main body material layer is 0.5 nm-1.5 nm. The thickness of the main body material layer is 0.5 nm-1.5 nm, which is conducive to further improving the efficiency of the laminated solar cell on the basis of facilitating the preparation of the main body material layer.

In a possible implementation, a thickness of the auxiliary material layer is less than 1 nm.

In the above technical solution, the provision of an auxiliary material layer with a smaller thickness is helpful to improve the efficiency of the laminated solar cell.

Optionally, the thickness of the auxiliary material layer is 0.5 nm-0.8 nm.

In a possible implementation, in the main body material layer, the metallic oxide includes at least one of: tin oxide, zinc oxide, and copper oxide, and a doped metal includes at least one of: aluminum, indium, and magnesium.

In the above technical solution, tin oxide, zinc oxide, copper oxide, etc. have better conductivity. In the main body material layer, providing the metal-doped metallic oxide is beneficial to further improving the conductivity of the main body material layer, thereby improving the conductivity of the tunneling structure, reducing the internal resistance of the laminated solar cell, and improving the fill factor and efficiency of the laminated solar cell. Aluminum and indium have better conductivity, and doping aluminum and indium into the metallic oxide is beneficial to improving the conductivity of the main body material layer. Magnesium has better light transmittance, and doping magnesium into the metallic oxide is beneficial to improving the light transmittance of the tunneling structure.

In a possible implementation, the metal-doped metallic oxide includes at least one of: indium-doped copper oxide, magnesium-doped copper oxide, and aluminum-doped copper oxide. Indium-doped copper oxide, magnesium-doped copper oxide, and aluminum-doped copper oxide have better stability and conductivity, which is beneficial to improving the stability and efficiency of the laminated solar cell.

In a possible implementation, the first light absorption layer is a perovskite layer, and the second light absorption layer is a perovskite layer. The first light absorption layer and the second light absorption layer are both perovskite layers, so that the laminated solar cell is a perovskite/perovskite laminated solar cell, which has higher efficiency.

In a possible implementation, a band gap of the first light absorption layer is larger than a band gap of the second light absorption layer.

In the above technical solution, the band gap of the first light absorption layer is larger than the band gap of the second light absorption layer, which is beneficial to improving the utilization rate of sunlight and improving the efficiency of the laminated solar cell.

In a possible implementation, a chemical formula of perovskite in the perovskite layer is ABX₃ or A₂CDX₆, where A includes an organic cation, an inorganic cation, or an organic-inorganic mixed cation, B includes an organic cation, an inorganic cation, or an organic-inorganic mixed cation, C includes an organic cation, an inorganic cation, or an organic-inorganic mixed cation, D includes an organic cation, an inorganic cation, or an organic-inorganic mixed cation, and X includes an organic anion, an inorganic anion, or an organic-inorganic mixed anion. In this way, a specific type of perovskite can be flexibly selected according to actual requirements.

In a possible implementation, A includes at least one of CH₃NH₃⁺, CH(NH₂)₂⁺, Li⁺, Na⁺, K⁺, Rb⁺, and Cs⁺, B includes at least one of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺, and X includes at least one of F⁻, Cl⁻, Br⁻, and I⁻.

In a possible implementation, A includes at least one of CH₃NH₃⁺ and CH(NH₂)₂⁺, B includes at least one of Pb²⁺ and Sn²⁺, and X includes at least one of Cl⁻, Br⁻, and I⁻.

In a possible implementation, the laminated solar cell further includes a first electrode layer and a second electrode layer, the first electrode layer, the first sub-cell, the tunneling structure, the second sub-cell, and the second electrode layer are sequentially arranged in the first direction, and a material of the first electrode layer includes a transparent metallic oxide.

In the above technical solution, sunlight can pass through the first electrode layer, so that the first light absorption layer and the second light absorption layer are irradiated by sunlight, thereby generating a photocurrent in the laminated solar cell.

In a possible implementation, a material of the second electrode layer includes at least one of: a metal and an alloy thereof, and a metallic oxide. In this way, a specific type of the material in the electrode layer can be flexibly selected according to actual requirements.

In a possible implementation, the material of the second electrode layer includes at least one of: Au, Ag, Cu, Al, Ni, Cr, Bi, Pt, Mg, Mo, and W.

In a possible implementation, the material of the first electrode layer includes at least one of: fluorine-doped tin oxide, indium-doped tin oxide, aluminum-doped zinc oxide, boron-doped zinc oxide, and indium-doped zinc oxide. In this way, the first electrode layer can have better conductivity and light transmittance.

In a possible implementation, a material of the hole transport layer includes a P-type semiconductor, and a material of the electron transport layer includes an N-type semiconductor. In this way, the material of the hole transport layer and the material of the electron transport layer can be flexibly selected according to actual conditions.

In a possible implementation, the material of the hole transport layer includes at least one of: poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide and its derivatives, or doped or passivated poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide. Optionally, the material of the electron transport layer includes at least one of: [6,6]-phenyl-C61-isomethyl butyrate, [6,6]-phenyl C71-methyl butyrate, C60, C70, tin dioxide, and zinc oxide and its derivatives, or doped or passivated [6,6]-phenyl-C61-isomethyl butyrate, [6,6]-phenyl C71-methyl butyrate, C60, C70, tin dioxide, and zinc oxide.

In a second aspect, a preparation method for a laminated solar cell is provided, including: providing a first sub-cell, a tunneling structure, and a second sub-cell. The first sub-cell includes a first carrier transport layer, a first light absorption layer, and a second carrier transport layer which are sequentially arranged in the first direction. The first direction is an incident direction of sunlight. The second sub-cell includes a third carrier transport layer, a second light absorption layer, and a fourth carrier transport layer which are sequentially arranged in the first direction. The tunneling structure includes a main body material layer and an auxiliary material layer. The main body material layer includes a metal-doped metallic oxide. The auxiliary material layer includes an N-type semiconductor material or a P-type semiconductor material. The auxiliary material layer is located between the main body material layer and the third carrier transport layer. The main body material layer is located between the second carrier transport layer and the auxiliary material layer. The laminated solar cell prepared by this method has higher efficiency and stability.

In a possible implementation, providing the first sub-cell, the tunneling structure, and the second sub-cell includes: preparing the metal-doped metallic oxide on the first sub-cell to prepare the main body material layer; preparing the N-type semiconductor material or the P-type semiconductor material on a surface of the main body material layer to prepare the tunneling structure; and preparing the second sub-cell on the tunneling structure. In this way, the laminated solar cell with the tunneling structure can be obtained through the above method.

In a possible implementation, preparing the N-type semiconductor material or the P-type semiconductor material on the surface of the main body material layer to prepare the tunneling structure includes: spin-coating a solution of the P-type semiconductor material on the surface of the main body material layer, wherein a concentration of the P-type semiconductor material in the solution is 0.005 mg/ml-0.05 mg/ml. In this way, the auxiliary material layer in the tunneling structure can be obtained.

In a possible implementation, the concentration of the P-type semiconductor material in the solution is 0.01 mg/ml-0.03 mg/ml.

In a third aspect, an electrical apparatus is provided, including the perovskite cell in the first aspect and any of the possible implementations thereof.

The example of the present application provides the laminated solar cell, including the first sub-cell, the tunneling structure, and the second sub-cell which are sequentially arranged in the first direction. The first direction is the incident direction of sunlight. The tunneling structure is located between the first sub-cell and the second sub-cell, and can electrically connect the first sub-cell and the second sub-cell to form the laminated cell. The first sub-cell includes the first carrier transport layer, the first light absorption layer, and the second carrier transport layer which are sequentially arranged in the first direction. The second sub-cell includes the third carrier transport layer, the second light absorption layer, and the fourth carrier transport layer which are sequentially arranged in the first direction. The first light absorption layer and the second light absorption layer can generate an electron-hole pair under the irradiation of sunlight, and the first carrier transport layer, the second carrier transport layer, the third carrier transport layer, and the fourth carrier transport layer can transport electrons or holes. The tunneling structure includes the main body material layer and the auxiliary material layer. The main body material layer includes the metal-doped metallic oxide. The auxiliary material layer includes the N-type semiconductor material or the P-type semiconductor material. By arranging the main body material layer, the resistance between the tunneling structure and the first sub-cell or the second sub-cell can be reduced, which is beneficial to improving a fill factor of the laminated solar cell. By arranging the auxiliary material layer, it is beneficial to reducing the recombination of carriers between the tunneling structure and the first sub-cell or the second sub-cell. The auxiliary material layer is located between the main body material layer and the third carrier transport layer, which is beneficial to reducing the carrier loss between the second carrier transport layer and the third carrier transport layer. The main body material layer is located between the second carrier transport layer and the auxiliary material layer, which is beneficial to reducing the resistance between the second carrier transport layer and the third carrier transport layer, and is beneficial to improving the fill factor of the laminated solar cell. Therefore, the technical solution of the example of the present application is beneficial to improving the efficiency of the laminated solar cell.

### BRIEF DESCRIPTION OF THE DRAWINGS

FIG. 1 is a schematic view of a laminated solar cell of an example of the present application.
FIG. 2 is a schematic view of a preparation method for a laminated solar cell of an example of the present application.
FIG. 3 is a schematic view of an electrical apparatus of an example of the present application.

### Reference numerals:

2: laminated solar cell; 21: first sub-cell; 22: second sub-cell; 23: tunneling structure; 231: main body material layer; 232: auxiliary material layer; 211: first carrier transport layer; 212: first light absorption layer; 213: second carrier transport layer; 221: third carrier transport layer; 222: second light absorption layer; 223: fourth carrier transport layer; 24: first electrode layer; 25: second electrode layer.

### DETAILED DESCRIPTON

Embodiments of a laminated solar cell and a preparation method therefor, and an electrical apparatus of the present application are specifically disclosed below with appropriate reference to the detailed description of the drawings. However, there may be cases where unnecessary detailed descriptions are omitted. For example, there are cases where detailed descriptions of well-known items and repeated descriptions of actually identical structures are omitted. This is to avoid unnecessary redundancy in the following descriptions and to facilitate understanding by those skilled in the art. In addition, the drawings and subsequent descriptions are provided for those skilled in the art to fully understand the present application, and are not intended to limit the subject matter recited in the claims.

The "ranges" disclosed in the present application are defined in the form of lower and upper limits. A given range is defined by selecting a lower limit and an upper limit, and the selected lower and upper limits define the boundaries of the particular range. A range defined in this manner may be inclusive or exclusive of end values, and may be arbitrarily combined, that is, any lower limit may be combined with any upper limit to form a range. For example, if the ranges of 60-120 and 80-110 are enumerated for a particular parameter, it is understood that the ranges of 60-110 and 80-120 are also contemplatable. Additionally, if the minimum range values 1 and 2 are listed, and if the maximum range values 3, 4 and 5 are listed, the following ranges are all contemplated: 1-3, 1-4, 1-5, 2- 3, 2-4 and 2-5. In the present application, unless stated otherwise, the numerical range "a-b" represents an abbreviated representation of any combination of real numbers between a to b, where both a and b are real numbers. For example, the numerical range "0-5" means that all the real numbers between "0-5" have been enumerated herein, and "0-5" is just an abbreviated representation of combinations of these numerical values. In addition, when a parameter is expressed as an integer greater than or equal to 2, it is equivalent to disclosing that the parameter is, for example, an integer of 2, 3, 4, 5, 6, 7, 8, 9, 10, 11, 12, and the like.

Unless otherwise specified, all embodiments and optional embodiments of the present application may be combined with each other to form new technical solutions.

Unless otherwise specified, all technical features and optional technical features of the present application may be combined with each other to form new technical solutions.

Unless otherwise specified, all steps of the present application may be performed sequentially or randomly, and preferably sequentially. For example, the method comprises steps (a) and (b), meaning that the method may comprise steps (a) and (b) performed sequentially, or may comprise steps (b) and (a) performed sequentially. For example, reference to "the method may further include step (c)" indicates that step (c) may be added to the method in any order, for example, the method may comprise steps (a), (b), and (c), or steps (a), (c), and (b), or steps (c), (a), and (b), etc.

As a type of solar cell, a laminated solar cell has a good application prospect due to its high photoelectric conversion efficiency. The arrangement of various film layers of the laminated solar cell is crucial to its efficiency, stability and other performance. The laminated solar cell generally includes a transparent conductive substrate, a first sub-cell, a tunneling structure, a second sub-cell, and a metal electrode layer. The tunneling structure is configured to connect the first sub-cell and the second sub-cell. The material of the tunneling structure is generally a metal material. However, the tunneling structure made of the metal material easily leads to a decrease in the stability of the laminated solar cell.

In order to improve the stability of the laminated solar cell, in some processing manner, the metal material is replaced with a metallic oxide material. However, compared with the metal material, the metallic oxide material has poor conductivity, which is not conducive to improving the efficiency of the laminated solar cell.

In view of this, the present application provides a laminated solar cell, including a first sub-cell, a tunneling structure, and a second sub-cell. A material of the tunneling structure includes a main body material layer and an auxiliary material layer, the main body material layer includes a metal-doped metallic oxide, and the auxiliary material layer includes an N-type semiconductor material or a P-type semiconductor material, thereby facilitating the improvement of the efficiency of the laminated solar cell.

### [Laminated solar cell]

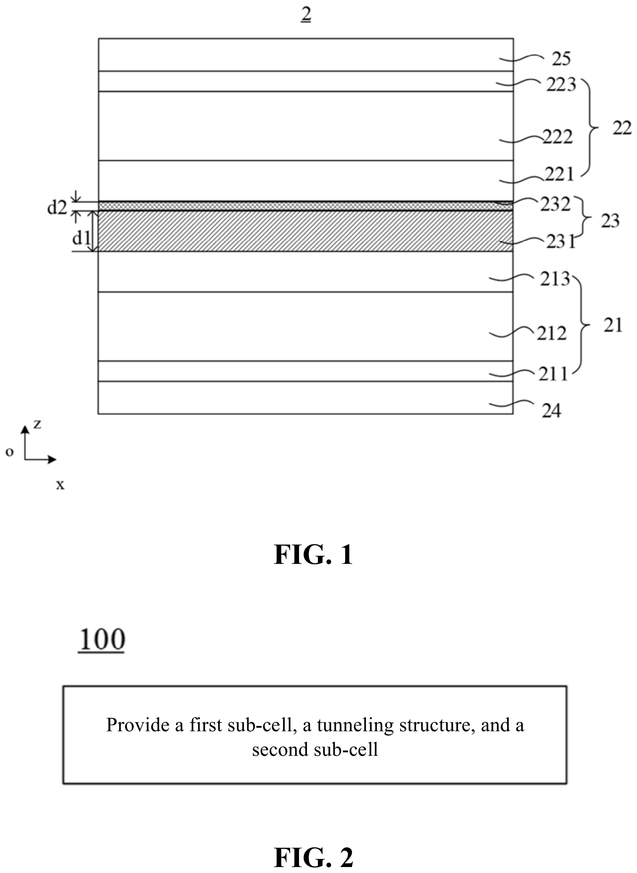

FIG. 1 is a schematic view of a laminated solar cell of an example of the present application. As shown in FIG. 1, the laminated solar cell 2 includes a first sub-cell 21, a tunneling structure 23, and a second sub-cell 22 which are sequentially arranged in a first direction, wherein the first direction is an incident direction of sunlight.

The first direction may also be a thickness direction of the laminated solar cell 2 . For example, the first direction is a Z direction in FIG. 1.

The first sub-cell 21 includes a first carrier transport layer 211, a first light absorption layer 212, and a second carrier transport layer 213 which are sequentially arranged in the first direction. The second sub-cell 22 includes a third carrier transport layer 221, a second light absorption layer 222, and a fourth carrier transport layer 223 which are sequentially arranged in the first direction.

The first light absorption layer 212 and the second light absorption layer 222 can generate electron-hole pairs under the irradiation of sunlight. Both electrons and holes can be called carriers.

The first carrier transport layer 211, the second carrier transport layer 213, the third carrier transport layer 221, and the fourth carrier transport layer 223 can transport the carriers. Specifically, according to the materials of the first carrier transport layer 211, the second carrier transport layer 213, the third carrier transport layer 221, and the fourth carrier transport layer 223, the above various film layers can transport electrons or holes.

The tunneling structure 23 is located between the first sub-cell 21 and the second sub-cell 22, and can connect the first sub-cell 21 and the second sub-cell 22, thereby facilitating the formation of the laminated solar cell 2.

The tunneling structure 23 includes a main body material layer 231 and an auxiliary material layer 232, the main body material layer 231 includes a metal-doped metallic oxide. The auxiliary material layer 232 includes an N-type semiconductor material or a P-type semiconductor material.

The metal-doped metallic oxide may refer to a metallic oxide doped with a certain content of metal. The doped metal may be different from the metal in the metallic oxide. For example, the metal-doped metallic oxide is indium-doped tin oxide, aluminum-doped copper oxide, etc.

The main body material layer 231 includes the metal-doped metallic oxide. Compared with the tunneling structure made of a metal, the tunneling structure 23 including the metal-doped metallic oxide has better performance. When the tunneling structure is applied to the laminated solar cell 2, the laminated solar cell 2 has higher stability. Compared with the tunneling structure made of the metallic oxide, the metal-doped metallic oxide has better conductivity. Therefore, the tunneling structure 23 of the example of the present application has better conductivity. When the tunneling structure is applied to the laminated solar cell 2, the laminated solar cell 2 has a higher current density and fill factor, so the laminated solar cell 2 has higher efficiency.

The auxiliary material layer 232 includes an N-type semiconductor material or a P-type semiconductor material. The N-type semiconductor material can transport holes, and the P-type semiconductor materials can transport electrons. Specifically, an arrangement can be made according to whether the auxiliary material layer 232 is in contact with the electron transport layer or the hole transport layer in the laminated solar cell 2. For example, in a case where the auxiliary material layer 232 is in contact with the hole transport layer, the auxiliary material layer 232 includes the N-type semiconductor material. In a case where the auxiliary material layer 232 is in contact with the electron transport layer, the auxiliary material layer 232 includes the P-type semiconductor material. The auxiliary material layer 232 is arranged to facilitate the transport of electrons or holes, to reduce the loss of electrons or holes between the first sub-cell 21 and the second sub-cell 22, and to improve the efficiency of the laminated solar cell 2.

The efficiency of the solar cell may refer to the conversion efficiency of the solar cell, which refers to a ratio of maximum output power of the cell when illuminated to power of incident light illuminating on the cell.

The fill factor of the solar cell can be used to measure photoelectric conversion efficiency of the solar cell. Generally speaking, the larger the fill factor, the greater the photoelectric conversion efficiency. The fill factor is related to the current density, which refers to a current per unit area. The larger the current area, the more conducive it is to improving the fill factor.

The auxiliary material layer 232 is located between the main body material layer 231 and the third carrier transport layer 221, and the main body material layer 231 is located between the second carrier transport layer 213 and the auxiliary material layer 232.

The materials of the auxiliary material layer 232 and the third carrier transport layer 221 are both N-type semiconductor materials, or the materials of the auxiliary material layer 232 and the third carrier transport layer 221 are both P-type semiconductor materials.

Optionally, the specific position of the auxiliary material layer 232 is related to a preparation order of the first sub-cell 21 and the second sub-cell 22. For example, in a process of preparing the laminated solar cell 2, the first sub-cell 21 is first prepared on a conductive glass substrate, then the main body material layer 231 is prepared on a surface of the first sub-cell 21, then the auxiliary material layer 232 is prepared on a surface of the main body material layer 231, and then the second sub-cell 22 is prepared on a surface of the auxiliary material layer 232.

The auxiliary material layer 232 is located between the main body material layer 231 and the third carrier transport layer 221. Thus, it is beneficial to reducing the loss of carriers between the second carrier transport layer 213 and the third carrier transport layer 221. The main body material layer 231 is located between the second carrier transport layer 213 and the auxiliary material layer 232, which is beneficial to reducing the resistance between the second carrier transport layer 213 and the third carrier transport layer 221, and is beneficial to improving the fill factor of the laminated solar cell 2. Therefore, the technical solution of the example is beneficial to improving the efficiency of the laminated solar cell 2.

An example of the present application provides a laminated solar cell 2, including a first sub-cell 21, q tunneling structure 23, and a second sub-cell 22 which are sequentially arranged in a first direction. The tunneling structure 23 is located between the first sub-cell 21 and the second sub-cell 22, and can electrically connect the first sub-cell 21 and the second sub-cell 22, thereby facilitating the formation of the laminated solar cell 2. The tunneling structure 23 includes a main body material layer 231 and an auxiliary material layer 232, the main body material layer 231 includes a metal-doped metallic oxide. The auxiliary material layer 232 includes an N-type semiconductor material or a P-type semiconductor material. The provision of the main body material layer 231 is beneficial to improving the fill factor and stability of the laminated solar cell 2. The provision of the auxiliary material layer 232 is beneficial to the transport of electrons or holes and to reducing the loss of electrons or holes between the first sub-cell 21 and the second sub-cell 22. Therefore, the technical solution of the example of the present application is beneficial to improving the efficiency and stability of the laminated solar cell 2.

In some examples, the first carrier transport layer 211 is a hole transport layer, the second carrier transport layer 213 is an electron transport layer, the third carrier transport layer 221 is a hole transport layer, the fourth carrier transport layer 223 is an electron transport layer, and the auxiliary material layer 232 includes the P-type semiconductor material.

In the example, the material of the auxiliary material layer 232 is the P-type semiconductor material. The third carrier transport layer 221 is the hole transport layer. Thus, it is beneficial to reducing the loss of carriers between the second carrier transport layer 213 and the third carrier transport layer 221, and is beneficial to improving the efficiency of the laminated solar cell 2.

In some examples, the P-type semiconductor material includes at least one of a compound (I) and a compound (II): 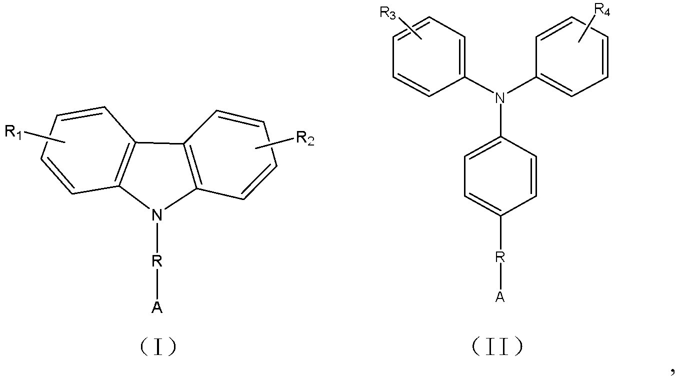
wherein A includes at least one of 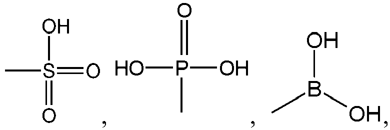 and -COOH;
R includes -(CH₂)ₙ-, where n is a natural number of 1 to 6; and
R₁, R₂, R₃, and R₄ each independently include at least one of -H, -CH₃, -C₂H₅, -OCH₃, - OC₂H₅, -X, -NH₂, and A, and X includes a halogen element.

n is a natural number of 1 to 6. For example, n is 1, 2, 3, 4, 5, and 6. R may include -CH₂-, -CH₂-CH₂-, -CH₂-CH₂-CH₂-, -CH₂-CH₂-CH_{2 -CH2}-CH₂-CH₂-.

The halogen element may include fluorine, chlorine, bromine, and iodine. -X may include at least one of -F, -Cl, -Br, and -I, the amino group is -NH₂, the methoxy group is CH₃O-, the ethoxy group is C₂H₅O-, the methyl group is -CH₃, and the ethyl group may be -C₂H₅.

Optionally, the P-type semiconductor includes at least one of: [4-(3,6-dimethyl-9H-carbazol-9-yl)butyl]phosphoric acid, 2-(4-(diphenylamino)phenyl)acetic acid, and [4-(3,6-dimethoxy-9H-carbazol-9-yl)butyl]phosphonic acid.

[4-(3,6-dimethyl-9H-carbazol-9-yl)butyl]phosphonic acid may also be referred to as Me-4PACz, and [4-(3,6-dimethoxy-9H-carbazol-9-yl)butyl]phosphonic acid may also be referred to as MeO-4PACz.

A structural formula of [4-(3,6-dimethyl-9H-carbazole-9-yl)butyl]phosphoric acid is:

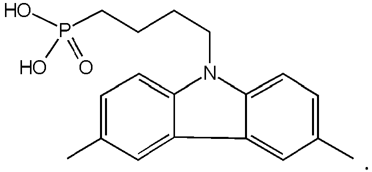

In 2-(4-(diphenylamino)phenyl)acetic acid, its structural formula satisfies a general formula of the compound (II), where R is -CH₂, A is -COOH, and R3 and R4 are both -H.

By selecting the compound (I) or the compound (II) as the material of the auxiliary material layer 232, the laminated solar cell 2 has a higher efficiency.

Optionally, the P-type semiconductor material includes a molecular self-assembly material. Molecular self-assembly can refer to the spontaneous formation of a materials with an ordered structure by basic structural units (molecules or certain fragments in molecules). For example, [4-(3,6-dimethyl-9H-carbazol-9-yl)butyl]phosphoric acid is a material formed by molecular self-assembly.

In some examples, the first carrier transport layer 211 is an electron transport layer, the second carrier transport layer 213 is a hole transport layer, the third carrier transport layer 221 is an electron transport layer, the fourth carrier transport layer 223 is a hole transport layer, and the auxiliary material layer 232 includes the N-type semiconductor material.

In the example, the material of the auxiliary material layer 232 is the N-type semiconductor material. The third carrier transport layer 221 is the electron transport layer. Thus, it is beneficial to reducing the loss of carriers between the second carrier transport layer 213 and the third carrier transport layer 221, and is beneficial to improving the efficiency of the laminated solar cell 2.

In some examples, a thickness d1 of the main body material layer 231 is 0.5 nm-2 nm. For example, d1 is 0.5 nm, 0.8 nm, 0.9 nm, 1 nm, 1.2 nm, 1.5 nm, 2 nm or any other value within the above range.

In a case where the thickness of the main body material layer 231 is not less than 0.5 nm, it is helpful to reduce the difficulty of preparing the main body material layer 231 and facilitate the preparation of the main body material layer 231. In a case where the thickness of the main body material layer 231 does not exceed 2 nm, it is helpful to reduce the loss of carriers and facilitate the transport of carriers, thereby helping to improve the efficiency of the laminated solar cell 2.

Optionally, the thickness d1 of the main body material layer 231 is 0.5 nm-1.5 nm. In this way, it is beneficial to further improve the efficiency of the laminated solar cell 2 on the basis of facilitating the preparation of the main body material layer 231.

In some examples, a thickness d2 of the auxiliary material layer 232 is less than 1 nm. For example, it is 0.1 nm or 0.9 nm. In this way, by providing the auxiliary material layer 232 with a smaller thickness, the laminated solar cell 2 can have higher efficiency.

Optionally, the thickness of the auxiliary material layer 232 is 0.5 nm-0.8 nm, for example, 0.5 nm, 0.6 nm, or 0.8 nm. In this way, the laminated solar cell 2 has higher efficiency.

In some examples, in the main body material layer 231, the metallic oxide includes at least one of: tin oxide, zinc oxide, and copper oxide, and a doped metal includes at least one of: aluminum, indium, and magnesium.

Among the metallic oxides, tin oxide, zinc oxide, and copper oxide have better conductivity. Among the metals, aluminum, indium, and magnesium have better conductivity. Therefore, in the main body material layer 231, providing the metal-doped metallic oxide is beneficial to further improving the conductivity of the main body material layer 231, thereby improving the conductivity of the tunneling structure 23, reducing the internal resistance of the laminated solar cell 2, and improving the fill factor and efficiency of the laminated solar cell 2.

Aluminum and indium have better conductivity, and doping aluminum and indium into the metallic oxide is beneficial to improving the conductivity of the main body material layer 231. Magnesium has better light transmittance, and doping magnesium into the metallic oxide is beneficial to improving the light transmittance of the tunneling structure 23, and to preparing the transparent laminated solar cell 2.

Optionally, the metallic oxide includes copper oxide. Copper oxide is easier to prepare and obtain, which helps to reduce the production cost.

Optionally, the metal-doped metallic oxide includes at least one of: indium-doped copper oxide, magnesium-doped copper oxide, and aluminum-doped copper oxide.

Indium-doped copper oxide, magnesium-doped copper oxide, and aluminum-doped copper oxide have better stability and conductivity, which is beneficial to improving the stability and efficiency of the laminated solar cell 2.

In some examples, the first light absorption layer 212 is a perovskite layer, and the second light absorption layer 222 is a perovskite layer. The first light absorption layer and the second light absorption layer are both perovskite layers, so that the laminated solar cell 2 is a perovskite/perovskite laminated solar cell 2, which has higher efficiency.

Optionally, the first light absorption layer 212 is a perovskite layer, and the second light absorption layer 222 is a copper indium gallium selenium layer. In the example of the present application, the material of the light absorption layer can be provided according to actual needs, and the present application includes but is not limited to this.

In some examples, a band gap of the first light absorption layer 212 is larger than a band gap of the second light absorption layer 222.

Specifically, the sunlight first passes through the first sub-cell 21 and then passes through the second sub-cell 22 . That is, the first light absorption layer 212 in the first sub-cell 21 absorbs a part of the sunlight, and the second light absorption layer 22 in the second sub-cell 22 absorbs another part of the sunlight, which is beneficial to improving the utilization efficiency of sunlight.

In this example, the band gap of the first light absorption layer 212 is larger than the band gap of the second light absorption layer 222, which is beneficial to improving the utilization rate of the sunlight and improving the efficiency of the laminated solar cell 2.

In some examples, a chemical formula of perovskite in the perovskite layer is ABX₃ or A₂CDX₆, where A includes an organic cation, an inorganic cation, or an organic-inorganic mixed cation, B includes an organic cation, an inorganic cation, or an organic-inorganic mixed cation, C includes an organic cation, an inorganic cation, or an organic-inorganic mixed cation, D includes an organic cation, an inorganic cation, or an organic-inorganic mixed cation, and X includes an organic anion, an inorganic anion, or an organic-inorganic mixed anion.

A includes an organic cation. For example, A may be CH₃NH₃⁺. A includes an inorganic cation. For example, A may be K⁺ and Rb⁺. A includes an organic-inorganic mixed cation. For example, A is a cation formed by assembling an organic cation and an inorganic cation. Similarly, the classification of ions in B, C, D, and X can be found in the description of A.

In the above example, a perovskite material with corresponding ions can be selected to prepare the perovskite layer according to actual needs.

Optionally, A includes at least one of CH₃NH₃⁺, CH(NH₂)₂⁺, Li⁺, Na⁺, K⁺, Rb⁺, and Cs⁺, B includes at least one of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺, and X includes at least one of F⁻, Cl⁻, Br⁻, and I⁻. Optionally, A includes at least one of CH₃NH₃⁺ and CH(NH₂)₂⁺, B includes at least one of Pb²⁺ and Sn²⁺, and X includes at least one of Cl⁻, Br⁻, and I⁻. In this way, a specific type of perovskite can be flexibly selected according to actual requirements.

In some examples, the perovskite may be Cs_{0.35}FA_{0.65}PbI_{1.8}Br_{1.2} and Cs_{0.09}FA_{0.77}MA_{0.14}Pb(I_{0.86}Br_{0.14})₃, where FA is a formamidine ion, and MA is a methylamine ion.

In some examples, the laminated solar cell 2 further includes a first electrode layer 24 and a second electrode layer 25, the first electrode layer 24, the first sub-cell 21, the tunneling structure 23, the second sub-cell 22, and the second electrode layer 25 are sequentially arranged in the first direction, and a material of the first electrode layer 24 includes a transparent metallic oxide.

In this example, sunlight can pass through the first electrode layer 24, so that the first light absorption layer 212 and the second light absorption layer 222 are irradiated by sunlight, thereby generating a photocurrent in the laminated solar cell 2.

In some examples, a material of the second electrode layer 25 includes at least one of: a metal and an alloy thereof, and a metallic oxide. In this way, a specific type of the material in the electrode layer can be flexibly selected according to actual requirements.

Optionally, the material of the second electrode layer 25 includes at least one of: Au, Ag, Cu, Al, Ni, Cr, Bi, Pt, Mg, Mo, and W. In this way, the above metals are all suitable for preparing the first electrode layer 24, so that the type of metal can be flexibly selected according to actual needs.

In some examples, the material in the first electrode layer 24 includes a metal and an alloy thereof, such as a silver-copper alloy and a molybdenum-tungsten alloy.

In some examples, the material of the first electrode layer 24 includes at least one of: fluorine-doped tin oxide (FTO), indium-doped tin oxide (ITO), aluminum-doped zinc oxide (AZO), boron-doped zinc oxide (BZO), and indium-doped zinc oxide (IZO). In this way, the first electrode layer 24 can have better conductivity and light transmittance.

Optionally, materials of the first electrode layer 24 and the second electrode layer 25 are both metallic oxides. For example, both are FTO.

In some examples, a material of the hole transport layer includes a P-type semiconductor, and a material of the electron transport layer includes an N-type semiconductor.

Optionally, the material of the hole transport layer includes at least one of: poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide and its derivatives, or doped or passivated poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide. A molecular formula of nickel oxide is NiOx, where a valence state of nickel may vary depending on the actual situation. Here, passivation may refer to some modifications of the hole transport layer with the aid of some small molecules or compounds. For example, the material of the hole transport layer includes nickel oxide. After the nickel oxide is prepared, a layer of small molecules is prepared on a surface of the nickel oxide to improve the performance of the hole transport layer.

Optionally, the material of the electron transport layer includes at least one of: [6,6]-phenyl-C61-isomethyl butyrate, [6,6]-phenyl C71-methyl butyrate, C60, C70, tin dioxide, and zinc oxide and its derivatives, or doped or passivated [6,6]-phenyl-C61-isomethyl butyrate, [6,6]-phenyl C71-methyl butyrate, C60, C70, tin dioxide, and zinc oxide. In this way, the material of the hole transport layer and the material of the electron transport layer can be flexibly selected according to actual conditions. Passivation may refer to some modifications of the electron transport layer with the aid of some small molecules or compounds. For example, the material of the electron transport layer includes tin dioxide. After the tin dioxide is prepared, a layer of small molecules is prepared on the surface of the tin dioxide to improve the performance of the electron transport layer.

In some examples, the laminated solar cell 2 further includes a plurality of cell units arranged in a second direction. The second direction is perpendicular to the first direction. For example, as shown in FIG. 1, the second direction is an x direction.

The laminated solar cell 2 includes a first groove, a second groove, and a connection structure. The first groove and the second groove are configured to isolate first electrode layers 24 and second electrode layers 25 of adjacent cell units, respectively, and the connection structure is configured to electrically connect a first electrode layer 24 of one cell unit and a second electrode layer 25 of the other cell unit in the adjacent cell units.

### [Preparation method for perovskite cell]

FIG. 2 is a preparation method for a perovskite cell of an example of the present application. As shown in FIG. 2, the method 100 includes: providing a first sub-cell 21, a tunneling structure 23, and a second sub-cell 22. The first sub-cell 21 includes a first carrier transport layer 211, a first light absorption layer 212, and a second carrier transport layer 213 which are sequentially arranged in the first direction. The first direction is an incident direction of sunlight. The second sub-cell 22 includes a third carrier transport layer 221, a second light absorption layer 222, and a fourth carrier transport layer 223 which are sequentially arranged in the first direction. The tunneling structure 23 includes a main body material layer 231 and an auxiliary material layer 232. The main body material layer 231 includes a metal-doped metallic oxide. The auxiliary material layer 232 includes an N-type semiconductor material or a P-type semiconductor material. The auxiliary material layer 232 is located between the main body material layer 231 and the third carrier transport layer 221. The main body material layer 231 is located between the second carrier transport layer 213 and the auxiliary material layer 232. The laminated solar cell 2 prepared by this method has higher efficiency and stability.

In some examples, the method 100 includes: preparing the metal-doped metallic oxide on the first sub-cell 21 to prepare the main body material layer 231; preparing the N-type semiconductor material or the P-type semiconductor material on a surface of the main body material layer 231 to prepare the tunneling structure 23; and preparing the second sub-cell 22 on the tunneling structure 23. In this way, the laminated solar cell 2 with the tunneling structure can be obtained through the above method.

In some examples, preparing the N-type semiconductor material or the P-type semiconductor material on the surface of the main body material layer 231 to prepare the tunneling structure 23 includes: spin-coating a solution of the P-type semiconductor material on the surface of the main body material layer 231, wherein a concentration of the P-type semiconductor material in the solution is 0.005 mg/ml-0.05 mg/ml, optionally, 0.01 mg/ml-0.03 mg/ml. In this way, the auxiliary material layer 232 in the tunneling structure can be obtained.

The concentration of the P-type semiconductor material in the solution may be 0.005 mg/ml, 0.01 mg/ml, 0.02 mg/ml, 0.03 mg/ml, 0.05 mg/ml or any value within the above range.

### [Electrical apparatus]

An example of the present application provides an electric device, which includes the perovskite cell in any of the above examples.

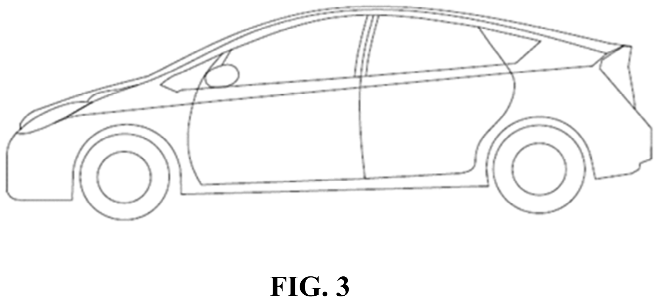

FIG. 3 is a schematic view of an electrical apparatus of an example of the present application. As shown in FIG. 3, the electrical apparatus may be a vehicle.

In some examples, the electrical apparatus may also be a lighting device, an energy storage device, etc. The example of the present application includes but is not limited to this.

### Examples

Examples of the present application will be described below. The examples described below are exemplary and only used to explain the present application, and are not to be construed as limiting the present application. In examples in which no specific technologies or conditions are specified, technologies or conditions described in the literature in the art or product specifications are followed.

### Example 1

Example 1 corresponds to the structure shown in FIG. 1 . In Example 1, a first electrode layer 24 is provided on a glass substrate. A material of the first electrode layer 24 is indium tin oxide (ITO). A material of a second electrode layer 25 is copper. A thickness of the second electrode layer 25 is 80 nm.

In a first sub-cell 21, a first carrier transport layer 211 is a hole transport layer, a second carrier transport layer 213 is an electron transport layer, a first light absorption layer 212 is a perovskite layer, and a material of the first light absorption layer 212 includes FA0.7MA0.3Pb0.5Sn0.5I3, FA is a formamidine ion, and MA is a methylamine ion.

In a second sub-cell 22, a third carrier transport layer 221 is a hole transport layer, a fourth carrier transport layer 223 is an electron transport layer, a second light absorption layer 222 is a perovskite layer, and a material of the second light absorption layer 222 includes FA0.8Cs0.2Pb(I0.6Br0.4)3.

The tunneling structure 23 is located between the second carrier transport layer 213 and the third carrier transport layer 221, and a main body material layer 231 is located between the second carrier transport layer 213 and the auxiliary material layer 232. A material of the main body material layer 231 is indium-doped copper oxide, and a thickness d1 of the main material layer 231 is 1 nm. A material of the auxiliary material layer 232 is 4-(3,6-dimethyl-9H-carbazole-9-yl)butyl]phosphoric acid, and a thickness d2 of the auxiliary material layer 232 is 0.5 nm.

### Examples 2-4

Examples 2-4 differ from Example 1 in that materials of auxiliary material layers 232 are different.

In Examples 2-4, the materials of the auxiliary material layers 232 are respectively: 2-(4-(diphenylamino)phenyl)acetic acid, [4-(3,6-dimethoxy-9H-carbazole-9-yl)butyl]phosphonic acid, and poly(3-hexylthiophene-2,5-diyl).

A structural formula of poly(3-hexylthiophene-2,5-diyl) satisfies:

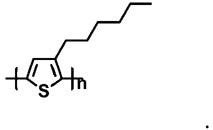

### Examples 5-7

Examples 5-7 differ from Example 1 in that materials of main body material layers 231 are different.

In Examples 5-7, the materials of the main material layers 231 are respectively: aluminum-doped copper oxide, magnesium-doped copper oxide, and indium-doped tin oxide.

### Example 8

Example 8 differs from Example 1 in that a first light absorption layer 212 is silicon, and a second light absorption layer 222 is a perovskite layer.

### Example 9

Example 9 differs from Example 1 in that a first carrier transport layer 211 is an electron transport layer, a second carrier transport layer 213 is a hole transport layer, a third carrier transport layer 221 is an electron transport layer, and a fourth carrier transport layer 223 is a hole transport layer. A material of an auxiliary material layer 232 is tin dioxide prepared by atomic layer deposition (ALD) technology.

### Examples 10-13

Examples 10-13 differ from Example 1 in that thicknesses of main body material layers 231 are different.

In Examples 10-13, the thicknesses of the main body material layers 231 are 0.5 nm, 0.8 nm, 1 nm, 1.5 nm, and 2 nm sequentially.

### Examples 14-15

Examples 14-15 differ from Example 1 in that thicknesses of auxiliary material layers 232 are different.

In Examples 1-15, the thickness of the first light absorption layer is 350 nm, the thickness of the second light absorption layer is 800 nm, the thickness of the first carrier transport layer is 20 nm, the thickness of the second carrier transport layer is 50 nm, the thickness of the third carrier transport layer is 20 nm, and the thickness of the fourth carrier transport layer is 50 nm.

### Comparative Example 1

Comparative Example 1 differs from Example 1 in that a tunneling structure in Comparative Example 1 does not include an auxiliary material layer, and a material of the tunneling structure is copper oxide.

### Comparative Example 2

Example 2 differs from Example 1 in that a tunneling structure in Comparative Example 2 does not include an auxiliary material layer, and a material of the tunneling structure is copper.

### Comparative Example 3

Comparative Example 3 differs from Example 1 in that a tunneling structure in Comparative Example 3 does not include an auxiliary material layer, and a material of the tunneling structure is copper oxide.

### Preparation method for the laminated solar cell in Example 1:

(1) 20 pieces of ITO conductive glass with a specification of 2.0 cm*2.0 cm were taken, 0.35 cm of ITO at two ends was removed by laser etching to expose a glass substrate; the etched ITO conductive glass was ultrasonically cleaned several times with water, acetone, and isopropyl alcohol sequentially; a solvent of the ITO conductive glass was blow-dried under a nitrogen gun, and further cleaning was performed in a ultraviolet ozone machine.
(2) After 2 mg/mL poly (bis(4-phenyl) (2,4,6-trimethylphenyl)amine) (PTAA) was spin-coated at a rate of 5000 rpm/s on the ultraviolet-ozone treated ITO conductive glass as a hole transport layer, annealing was performed on a hot bench at 100°C for 10 min.
(3) a perovskite precursor solution was spin-coated at 1000-5000 rpm/s on the hole transport layer, annealing was performed at 100°C for 30 min, and cooling was performed to room temperature to prepare a perovskite layer. A band gap of the perovskite layer is 1.3 eV.
(4) The perovskite layer was spin-coated with ([6,6]-phenyl C61 butyric acid methyl ester (PCBM)) at 1000-1500 rpm/s and annealed at 100°C for 10 min to prepare an electron transport layer. Immediately after, its passivation layer of bathocuproine (BCP) was spin-coated at 5000 rpm/s.
(5) The product obtained in step (4) was placed in a magnetron sputtering device to deposit indium-doped copper oxide to prepare a main body material layer in the tunneling structure. Thereafter, 0.03 mg/mL of phosphate carbazole small molecules was spin-coated at a rate of 5000 rpm/s, and annealed for standby use to obtain an auxiliary material layer of the tunneling structure, thereby obtaining the tunneling structure.
(6) After the hole transport layer of 2 mg/mL of poly(bis(4-phenyl) (2,4,6-trimethylphenyl)amine) (PTAA) was spin-coated at a rate of 5000 rpm/s on the tunneling structure, annealing was performed on a hot bench at 100°C for 10 min.
(7) A perovskite precursor solution was spin-coated at 1000-5000 rpm/s on the hole transport layer, annealing was performed at 100°C for 30 min, and cooling was performed to room temperature. A band gap of perovskite is 1.7 eV.
(8) The perovskite layer was spin-coated with an electron transport layer of [6,6]-phenyl C61 butyric acid methyl ester (PCBM) at 1000-1500 rpm/s and annealed at 100°C for 10 min. Immediately after, its passivation layer of bathocuproine (BCP) was spin-coated at 5000 rpm/s.
(9) The product obtained in step (8) was placed in a thermal evaporator, and a copper electrode was evaporated to 80 nm at a rate of 1 A/s to complete the preparation of the laminated solar cell.

The preparation methods of other examples and comparative examples are substantially the same as that of Example 1. For similar details, reference may be made to the description of the preparation method of Example 1, which will not be repeated here.

**Table 1 Specific data of examples and comparative examples**

| | First light absorption layer | Second light absorption layer | Main body material layer | | Auxiliary material layer | |
|---|---|---|---|---|---|---|
| | | | Material | d1/nm | Material | d2/n m |
| Example 1 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | [4-(3,6-dimethyl-9H-carbazole-9-yl)butyl]phosphoric acid | 0.5 |
| Example 2 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | 2-(4-(diphenylamino) phenyl)acetic acid | 0.5 |
| Example 3 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | [4-(3,6-dimethoxy-9H-carbazol-9-yl)butyl]phosphonic acid | 0.5 |
| Example 4 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | Poly(3-hexylthiophene-2,5-diyl) | 0.5 |
| Example 5 | FA_{0.7}MA_{0.3} Pb_{0.5}Sn_{0.5}I₃ | FA_{0.8}Cs_{0.2}P b(I_{0.6}Br_{0.4})₃ | Aluminum doped copper oxide | 1 | [4-(3,6-dimethyl-9H-carbazole-9-yl)butyl]phosphoric acid | 0.5 |
| Example 6 | FA_{0.7}MA_{0.3} Pb_{0.5}Sn_{0.5}I₃ | FA_{0.8}Cs_{0.2}P b(I_{0.6}Br_{0.4})₃ | Magnesium doped copper oxide | 1 | [4-(3,6-dimethyl-9H-carbazole-9-yl)butyl]phosphoric acid | 0.5 |
| Example 7 | FA_{0.7}MA_{0.3} Pb_{0.5}Sn_{0.5}I₃ | FA_{0.8}Cs_{0.2}P b(I_{0.6}Br_{0.4})₃ | Indium-doped tin oxide | 1 | [4-(3,6-dimethyl-9H-carbazole-9-yl)butyl]phosphoric acid | 0.5 |
| Example 8 | Silicon | FA_{0.8}Cs_{0.2}P b(I_{0.6}Br_{0.4})₃ | Indium-doped copper oxide | 1 | [4-(3,6-dimethyl-9H-carbazole-9-yl)butyl]phosphoric acid | 0.5 |
| Example 9 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | ALD tin dioxide | 0.5 |
| Example 10 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 0.5 | [4-(3,6-dimethyl-9H-carbazole-9-yl)butyl]phosphoric acid | 0.5 |
| Example 11 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 0.8 | [4-(3,6-dimethyl-9H-carbazole-9-yl)butyl]phosphoric acid | 0.5 |
| Example 12 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1.5 | [4-(3,6-dimethyl-9H-carbazole-9-yl)butyl]phosphoric acid | 0.5 |
| Example 13 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 2 | [4-(3,6-dimethyl-9H-carbazole-9-yl)butyl]phosphoric acid | 0.5 |
| Example 14 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | [4-(3,6-dimethyl-9H-carbazole-9-yl)butyl]phosphoric acid | 0.8 |
| Example 15 | FA_{0.7}MA_{0.3} Pb_{0.5}Sn_{0.5}I₃ | FA_{0.8}Cs_{0.2}P b(I_{0.6}Br_{0.4})₃ | Indium-doped copper oxide | 1 | [4-(3,6-dimethyl-9H-carbazole-9-yl)butyl]phosphoric acid | 1.5 |
| Comparative example 1 | FA_{0.7}MA_{0.3} Pb_{0.5}Sn_{0.5}I₃ | FA_{0.8}Cs_{0.2}P b(I_{0.6}Br_{0.4})₃ | Copper oxide | 1 | / | / |
| Comparative example 2 | FA_{0.7}MA_{0.3} Pb_{0.5}Sn_{0.5}I₃ | FA_{0.8}Cs_{0.2}P b(I_{0.6}Br_{0.4})₃ | Copper | 1 | / | / |
| Comparative example 3 | FA_{0.7}MA_{0.3} Pb_{0.5}Sn_{0.5}I₃ | FA_{0.8}Cs_{0.2}P b(I_{0.6}Br_{0.4})₃ | Indium doped copper oxide | 1 | / | / |

**Table 2 Test results of examples and comparative examples**

| | Jsc (mA·cm-2) | Voc (V) | FF (%) | PCE (%) |
|---|---|---|---|---|
| Example 1 | 16.07 | 1.903 | 78.12 | 23.89 |
| Example 2 | 15.84 | 1.883 | 79.12 | 23.59 |
| Example 3 | 15.79 | 1.901 | 77.83 | 23.36 |
| Example 4 | 15.57 | 1.722 | 75.1 | 20.13 |
| Example 5 | 15.89 | 1.831 | 76.91 | 22.37 |
| Example 6 | 15.93 | 1.862 | 77 | 22.83 |
| Example 7 | 16 | 1.803 | 78.11 | 22.53 |
| Example 8 | 15.88 | 1.762 | 79.82 | 22.33 |
| Example 9 | 15.32 | 1.783 | 78.12 | 21.33 |
| Example 10 | 16.01 | 1.891 | 78.22 | 23.68 |
| Example 11 | 16.03 | 1.899 | 78.2 | 23.80 |
| Example 12 | 15.72 | 1.9 | 77.13 | 23.03 |
| Example 13 | 15.02 | 1.899 | 74.32 | 21.19 |
| Example 14 | 16.03 | 1.883 | 78.02 | 23.54 |
| Example 15 | 16 | 1.853 | 77.93 | 23.10 |
| Comparative Example 1 | 12.1 | 1.503 | 73.12 | 13.29 |
| Comparative Example 2 | 11.2 | 1.104 | 60.32 | 7.45 |
| Comparative Example 3 | 14.87 | 1.692 | 74.17 | 18.66 |

### [Efficiency test of laminated solar cell]

Under the irradiation of standard simulated sunlight (AM 1.5G, 100 mW/cm²), the cell performance was tested to obtain an I-V curve. The short-circuit current Jsc (in mA/cm2), the open-circuit voltage Voc (in V), the maximum light output current Jmpp (in mA) and the maximum light output voltage Vmpp (in V) can be obtained according to the I-V curve and the data fed back by a test device. The fill factor FF (in %) of the cell was calculated using the formula FF=Jsc×Voc/(Jmpp×Vmpp). The photoelectric conversion efficiency PCE (in %) of the cell was calculated by the formula PCE=Jsc×Voc×FF/Pw. Pw represents the input power, in mW.

### [Test of main body material layer]

The main body material layer was prepared by an evaporation device, and the thickness of the main body material layer can be determined by a value displayed on the evaporation device. In addition, the thickness of the main body material layer can be tested with the help of an ellipsometer, and the material in the main body material layer can be determined by X-ray photoelectron spectroscopy (XPS).

### [Test of auxiliary material layer]

The thickness of the auxiliary material layer is smaller, and the existence of corresponding materials in the auxiliary material layer can be determined by X-ray photoelectron spectroscopy (XPS), that is, the existence of the auxiliary material layer can be determined, and the thickness can be measured with the aid of an ellipsometer.

In combination with Examples 1-15 and Comparative Examples 1-3, by providing the main body material layer and the auxiliary material layer, the laminated solar cell has a higher fill factor and efficiency. As shown in combination with Examples 1-4 and Comparative Example 3, by providing the auxiliary material layer, and by providing the auxiliary material layer as the P-type semiconductor material, the efficiency of the laminated solar cell is improved. As shown in combination with Examples 1-3 and Example 4, selecting a compound with a specific structure as the material of the auxiliary material layer is beneficial to further improving the efficiency of the laminated solar cell. As shown in combination with Example 1 and Examples 5-7, a specific metal-doped metallic oxide is selected as the material of the main body material layer, which can have higher efficiency. As shown in combination with Example 8, the light absorption layer of the laminated solar cell can be a light absorption layer other than the perovskite absorption layer, that is, the configuration of the example of the present application can be applied to laminated solar cells with a variety of different light absorption layer materials. As shown in combination with Example 9, the laminated solar cell can be a laminated solar cell with an upright structure. In this case, the material of the auxiliary material layer can be tin dioxide prepared by atomic deposition. As shown in combination with Example 1, Example 1 is a laminated solar cell of an inverted structure. The laminated solar cell of the inverted structure has higher efficiency. As shown in combination with Examples 10-13, when the thickness of the main body material layer in the laminated solar cell is 0.5 nm-1.5 nm, it has higher efficiency. As shown in combination with Examples 14-15, when the thickness of the auxiliary material layer is less than 1 nm, it has higher efficiency. Further, when the thickness of the auxiliary material layer is 0.5 nm-0.8 nm, it has higher efficiency.

It should be noted that the present application is not limited to the above embodiments. The above embodiments are only examples, and embodiments that have the same composition and exert the same effect as the technical ideas within the scope of the technical solution of the present application are included in the technical scope of the present application. In addition, without departing from the scope of the subject matter of the present application, various modifications that can be conceived by those skilled in the art are applied to the embodiments, and other modes constructed by combining some of the constituent elements of the embodiments are also included in the scope of the present application.

## Claims

1. A laminated solar cell, comprising:
a first sub-cell, a tunneling structure, and a second sub-cell which are sequentially arranged in a first direction, wherein the first direction is an incident direction of sunlight;
wherein
the first sub-cell comprises a first carrier transport layer, a first light absorption layer, and a second carrier transport layer which are sequentially arranged in the first direction;
the second sub-cell comprises a third carrier transport layer, a second light absorption layer, and a fourth carrier transport layer which are sequentially arranged in the first direction; and
the tunneling structure comprises a main body material layer and an auxiliary material layer, the main body material layer comprises a metal-doped metallic oxide, the auxiliary material layer comprises an N-type semiconductor material or a P-type semiconductor material, the auxiliary material layer is located between the main body material layer and the third carrier transport layer, and the main body material layer is located between the second carrier transport layer and the auxiliary material layer.

2. The laminated solar cell according to claim 1, wherein the first carrier transport layer is a hole transport layer, the second carrier transport layer is an electron transport layer, the third carrier transport layer is a hole transport layer, the fourth carrier transport layer is an electron transport layer, and the auxiliary material layer comprises the P-type semiconductor material.

3. The laminated solar cell according to claim 1 or 2, wherein the P-type semiconductor material comprises at least one of a compound (I) and a compound (II): 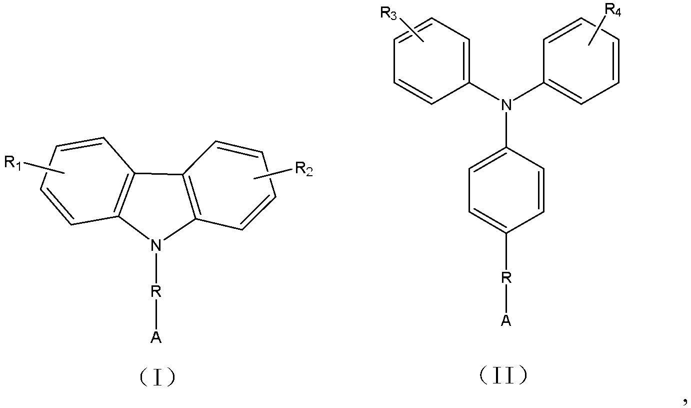
wherein A comprises at least one of 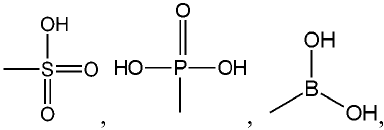 and -COOH;
R comprises -(CH₂)ₙ-, where n is a natural number of 1 to 6; and
R₁, R₂, R₃, and R₄ each independently comprise at least one of -H, -CH₃, -C₂H₅, -OCH₃, - OC₂H₅, -X, -NH₂, and A, and X comprises a halogen element.

4. The laminated solar cell according to claim 3, wherein the P-type semiconductor material comprises at least one of: [4-(3,6-dimethyl-9H-carbazol-9-yl)butyl]phosphoric acid, 2-(4-(diphenylamino)phenyl)acetic acid, and [4-(3,6-dimethoxy-9H-carbazol-9-yl)butyl]phosphonic acid.

5. The laminated solar cell according to claim 1, wherein the first carrier transport layer is an electron transport layer, the second carrier transport layer is a hole transport layer, the third carrier transport layer is an electron transport layer, the fourth carrier transport layer is a hole transport layer, and the auxiliary material layer comprises the N-type semiconductor material.

6. The laminated solar cell according to claim 5, wherein the N-type semiconductor material comprises tin dioxide.

7. The laminated solar cell according to any one of claims 1-6, wherein a thickness of the main body material layer is 0.5 nm-2 nm.

8. The laminated solar cell according to claim 7, wherein the thickness of the main body material layer is 0.5 nm-1.5 nm.

9. The laminated solar cell according to any one of claims 1-8, wherein a thickness of the auxiliary material layer is less than 1 nm.

10. The laminated solar cell according to claim 9, wherein the thickness of the auxiliary material layer is 0.5 nm-0.8 nm.

11. The laminated solar cell according to any one of claims 1-10, wherein in the main body material layer, the metallic oxide comprises at least one of: tin oxide, zinc oxide, and copper oxide, and a doped metal comprises at least one of: aluminum, indium, and magnesium.

12. The laminated solar cell according to claim 11, wherein the metal-doped metallic oxide comprises at least one of: indium-doped copper oxide, magnesium-doped copper oxide, and aluminum-doped copper oxide.

13. The laminated solar cell according to any one of claims 1-12, wherein the first light absorption layer is a perovskite layer, and the second light absorption layer is a perovskite layer.

14. The laminated solar cell according to claim 13, wherein a band gap of the first light absorption layer is larger than a band gap of the second light absorption layer.

15. The laminated solar cell according to claim 13 or 14, wherein a chemical formula of perovskite in the perovskite layer is ABX₃ or A₂CDX₆, where
A comprises an organic cation, an inorganic cation, or an organic-inorganic mixed cation, B comprises an organic cation, an inorganic cation, or an organic-inorganic mixed cation, C comprises an organic cation, an inorganic cation, or an organic-inorganic mixed cation, D comprises an organic cation, an inorganic cation, or an organic-inorganic mixed cation, and X comprises an organic anion, an inorganic anion, or an organic-inorganic mixed anion.

16. The laminated solar cell according to claim 15, wherein A comprises at least one of CH₃NH₃⁺, CH(NH₂)₂⁺, Li⁺, Na⁺, K⁺, Rb⁺, and Cs⁺, B comprises at least one of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺, and X comprises at least one of F⁻, Cl⁻, Br⁻, and I⁻.

17. The laminated solar cell according to claim 16, wherein A comprises at least one of CH₃NH₃⁺ and CH(NH₂)₂⁺, B comprises at least one of Pb²⁺ and Sn²⁺, and X comprises at least one of Cl⁻, Br⁻, and I⁻.

18. The laminated solar cell according to any one of claims 1-17, wherein the laminated solar cell further comprises a first electrode layer and a second electrode layer, the first electrode layer, the first sub-cell, the tunneling structure, the second sub-cell, and the second electrode layer are sequentially arranged in the first direction, and a material of the first electrode layer comprises a transparent metallic oxide.

19. The laminated solar cell according to claim 18, wherein a material of the second electrode layer comprises at least one of: a metal and an alloy thereof, and a metallic oxide.

20. The laminated solar cell according to claim 19, wherein the material of the second electrode layer comprises at least one of: Au, Ag, Cu, Al, Ni, Cr, Bi, Pt, Mg, Mo, and W.

21. The laminated solar cell according to claim 18 or 19, wherein the material of the first electrode layer comprises at least one of: fluorine-doped tin oxide, indium-doped tin oxide, aluminum-doped zinc oxide, boron-doped zinc oxide, and indium-doped zinc oxide.

22. The laminated solar cell according to claim 2 or 5, wherein a material of the hole transport layer comprises a P-type semiconductor, and a material of the electron transport layer comprises an N-type semiconductor.

23. The laminated solar cell according to claim 22, wherein the material of the hole transport layer comprises at least one of: poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide and its derivatives, or doped or passivated poly[bis(4-phenyl)(2,4,6-trimethylphenyl)amine], poly-3-hexylthiophene, triphenylamine with triptycene as a core, 3,4-ethylenedioxythiophene-methoxytriphenylamine, N-(4-aniline)carbazole-spirobifluorene, poly(3,4-ethylenedioxythiophene):poly(styrene sulfonate), polythiophene, nickel oxide, molybdenum oxide, cuprous iodide, and cuprous oxide; and the material of the electron transport layer comprises at least one of: [6,6]-phenyl-C61-isomethyl butyrate, [6,6]-phenyl C71-methyl butyrate, C60, C70, tin dioxide, and zinc oxide and its derivatives, or doped or passivated [6,6]-phenyl-C61-isomethyl butyrate, [6,6]-phenyl C71-methyl butyrate, C60, C70, tin dioxide, and zinc oxide.

24. A preparation method for a laminated solar cell, comprising:
providing a first sub-cell, a tunneling structure, and a second sub-cell;
wherein
the first sub-cell comprises a first carrier transport layer, a first light absorption layer, and a second carrier transport layer which are sequentially arranged in a first direction, and the first direction is an incident direction of sunlight;
the second sub-cell comprises a third carrier transport layer, a second light absorption layer, and a fourth carrier transport layer which are sequentially arranged in the first direction; and
the tunneling structure comprises a main body material layer and an auxiliary material layer, the main body material layer comprises a metal-doped metallic oxide, the auxiliary material layer comprises an N-type semiconductor material or a P-type semiconductor material, the auxiliary material layer is located between the main body material layer and the third carrier transport layer, and the main body material layer is located between the second carrier transport layer and the auxiliary material layer.

25. The preparation method according to claim 24, wherein providing the first sub-cell, the tunneling structure, and the second sub-cell comprises:
preparing the metal-doped metallic oxide on the first sub-cell to prepare the main body material layer;
preparing the N-type semiconductor material or the P-type semiconductor material on a surface of the main body material layer to prepare the tunneling structure; and
preparing the second sub-cell on the tunneling structure.

26. The preparation method according to claim 25, wherein preparing the N-type semiconductor material or the P-type semiconductor material on the surface of the main body material layer to prepare the tunneling structure comprises:
spin-coating a solution of the P-type semiconductor material on the surface of the main body material layer, wherein a concentration of the P-type semiconductor material in the solution is 0.005 mg/ml-0.05 mg/ml.

27. The preparation method according to claim 26, wherein the concentration of the P-type semiconductor material in the solution is 0.01 mg/ml-0.03 mg/ml.

28. An electrical apparatus, comprising the laminated solar cell according to any one of claims 1-23.
